# EUROPEAN PATENT APPLICATION

(11) **EP 4 340 143 A1**
(43) Date of publication of application: **20.03.2024**
(21) Application number: 22868555.8
(22) Date of filing: 15.02.2022
(51) Int. Cl.: H01S 5/183, H01S 5/042

(54) **VERTICAL CAVITY SURFACE EMITTING LASER**

(30) Priority: 18.09.2021 CN 202111098107
(71) Applicant: Vertilite Co., Ltd., Changzhou, Jiangsu (CN)
(72) Inventor: WENG, Weicheng, hangzhou, Jiangsu 213000 (CN); LIANG, Dong, hangzhou, Jiangsu 213000 (CN); LIU, Song, hangzhou, Jiangsu 213000 (CN)
(74) Representative: Gill Jennings & Every LLP
(86) International application number: PCT/CN2022/076275
(87) International publication number: WO 2023/040175

(57) **Abstract**

Provided VCSEL includes emitters arranged in an array disposed on a surface of a substrate, a first passivation layer disposed on a surface of the emitters facing away from the substrate and provided with a first via, a second passivation layer provided with a second via, and a first pad. The first pad includes first sub-pads and at least one second sub-pad, a number of the first sub-pads is equal to a number of the emitters, the first sub-pads are disposed on a side of the first passivation layer facing away from the substrate and connected to the emitters through the first via, the second passivation layer covers the first sub-pads and the first passivation layer, and the at least one second sub-pad is connected to the first sub-pads through the second via.

## Description

This application claims priority to Chinese Patent Application No. 202111098107.0 filed with the China National Intellectual Property Administration (CNIPA) on Sep. 18, 2021, the disclosure of which is incorporated herein by reference in its entirety.

### TECHNICAL FIELD

The present application relates to the field of semiconductor technologies, for example, a vertical cavity surface emitting laser.

### BACKGROUND

A vertical cavity surface emitting laser (VCSEL) is a new type of laser emitting light from a vertical surface. Due to its advantages of a small volume, a circular output spot, a low threshold current, high modulation frequency, easy fiber coupling, and an easily-formed large area array, the VCSEL is widely applied in optical communication, optical interconnection, optical information processing, a mobile phone, a light detection and ranging (Lidar) in the unmanned vehicles and other fields.

The VCSEL includes a substrate and multiple emitters arranged in an array on a surface of the substrate. Due to a limitation of the structural arrangement, among the emitters arranged in the array, the same ends of the multiple emitters shares one common pad disposed on a side of the emitters facing away from the substrate, a minimum spacing is provided between different common pads, and one common pad covers multiple emitters corresponding to this one common pad and a spacing region between these multiple emitters, resulting in that the spacing between emitters corresponding to different common pads cannot be further reduced, resulting in that the density of the emitters is relatively sparse.

### SUMMARY

The present application provides a VCSEL to increase the density between emitters in the VCSEL.

The present application provides a VCSEL. The VCSEL includes a substrate, emitters arranged in an array, a first passivation layer, a second passivation layer, and a first pad.

The emitters arranged in the array are disposed on a surface of the substrate. The first passivation layer is disposed on a surface of the emitters arranged in the array facing away from the substrate and provided with a first via. The second passivation layer is provided with a second via.

The first pad includes a plurality of first sub-pads and at least one second sub-pad, a number of the plurality of first sub-pads is equal to a number of the emitters arranged in the array, each of the plurality of first sub-pads is disposed on a side of the first passivation layer facing away from the substrate and connected to a respective emitter of the emitters through the first via, the second passivation layer covers the plurality of first sub-pads and the first passivation layer, and each of the at least one second sub-pad is connected to a respective first sub-pad of the plurality of first sub-pads through the second via.

### BRIEF DESCRIPTION OF DRAWINGS

FIG. 1 is a top view of a VCSEL in the related art;
FIG. 2 is a sectional view of the VCSEL in FIG. 1 taken along the A1-A2 direction;
FIG. 3 is a top view of a VCSEL according to an embodiment of the present application;
FIG. 4 is a sectional view of the VCSEL in FIG. 3 taken along the B1-B2 direction;
FIG. 5 is another sectional view of the VCSEL in FIG. 3 taken along the B1-B2 direction;
FIG. 6 is another top view of a VCSEL according to an embodiment of the present application;
FIG. 7 is another top view of a VCSEL according to an embodiment of the present application;
FIG. 8 is another top view of a VCSEL according to an embodiment of the present application;
FIG. 9 is a sectional view of the VCSEL in FIG. 8 taken along the B1-B2 direction;
FIG. 10 is a sectional view of the VCSEL in FIG. 8 taken along the C1-C2 direction;
FIG. 11 is a sectional view of the VCSEL in FIG. 8 taken along the D1-D2 direction;
FIG. 12 is another top view of a VCSEL according to an embodiment of the present application;
FIG. 13 is another top view of a VCSEL according to an embodiment of the present application;
FIG. 14 is another top view of a VCSEL according to an embodiment of the present application; and
FIG. 15 is another top view of a VCSEL according to an embodiment of the present application.

### DETAILED DESCRIPTION

The present application is described below in conjunction with drawings and embodiments. The specific embodiments set forth below are intended to explain the preset application. For ease of description, only part of structures related to the present application are illustrated in the drawings.

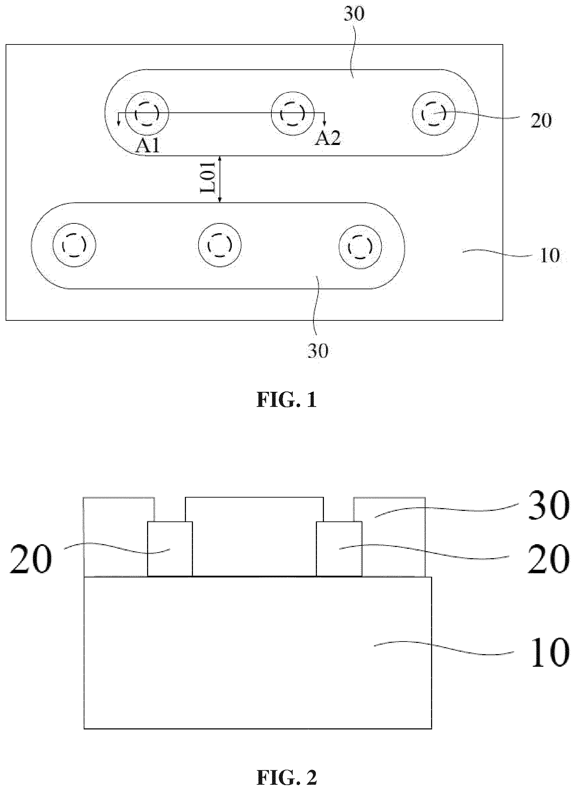

A VCSEL includes multiple emitters arranged in an array, and the density of the emitters is relatively sparse. FIG. 1 is a top view of a VCSEL in the related art. FIG. 2 is a sectional view of the VCSEL in FIG. 1 taken along the A1-A2 direction. In an example, FIG. 1 shows a substrate 10 and emitters 20 arranged in two rows on a surface of the substrate 10. First ends of each row of emitters 20 share a first pad 30 disposed on a side of the emitters 20 facing away from the substrate 10, and the first pad 30 is used as a common pad covering multiple corresponding emitters 20 and spacings between the multiple corresponding emitters 20. If a spacing between the first pad 30 of the emitters 20 in the first row and the first pad 30 of the emitters 20 in the second row is too small, in a process of forming individual first pads 30 through photolithography and etching processes, a ratio of a length to a width of photoresist distributed at the spacing between the first pad 30 of the emitters 20 in the first row and the first pad 30 of the emitters 20 in the second row is too large, resulting in that the photoresist is easily inclined. Therefore, it is necessary to maintain a minimum spacing L01 between the first pad 30 corresponding to the emitters 20 in the first row and the first pad 30 corresponding to the emitters 20 in the second row to be greater than or equal to a theoretical distance. In summary, the emitters 20 in the second row cannot be disposed in a spacing region of the emitters 20 in the first row or adjacent to the spacing region, so as to avoid the problem that the photoresist between the emitters 20 in different rows is easily inclined. Therefore, the minimum spacing between the emitters 20 in different rows in the related art cannot be continuously reduced, resulting in a relatively small density of the emitters 20.

To solve preceding technical problems, embodiments of the present application provide the technical solution described below.

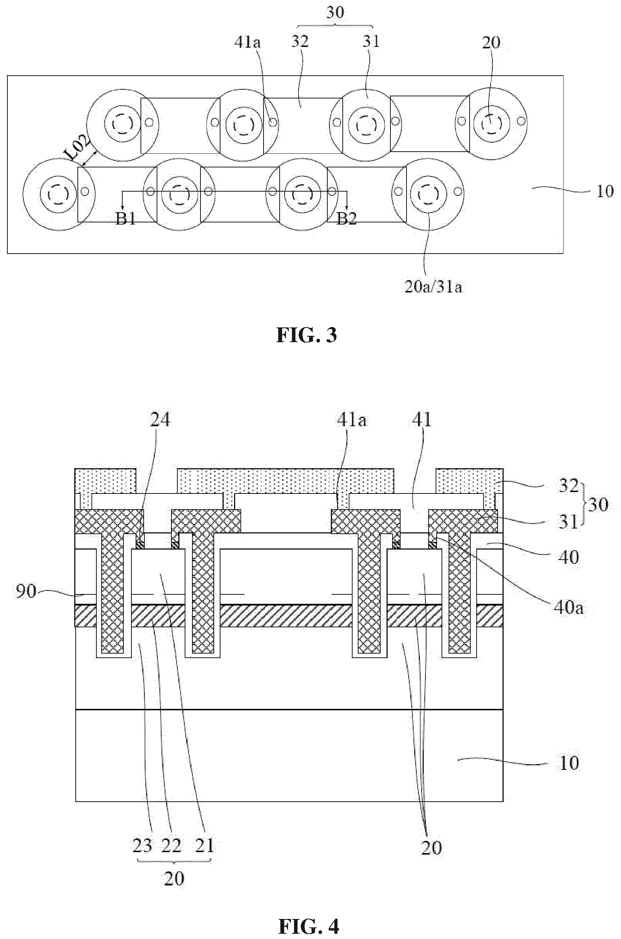

FIG. 3 is a top view of a VCSEL according to an embodiment of the present application. FIG. 4 is a sectional view of the VCSEL in FIG. 3 taken along the B1-B2 direction. Referring to FIGS. 3 and 4, the VCSEL includes a substrate 10, emitters 20 arranged in an array disposed on a surface of the substrate 10, a first passivation layer 40, a second passivation layer 41, and a first pad 30. The first passivation layer 40 is disposed on a surface of the emitters 20 arranged in the array facing away from the substrate 10 and provided with first vias 40a. The second passivation layer 41 is provided with second vias 41a. The first pad 30 includes multiple first sub-pads 31 and at least one second sub-pad 32, a number of the multiple first sub-pads 31 is equal to a number of the emitters 20 arranged in the array, each of the first sub-pads 31 is disposed on a side of the first passivation layer 40 facing away from the substrate 10 and connected to a respective emitter 20 through a respective first via 40a, the second passivation layer 41 covers the multiple first sub-pads 31 and the first passivation layer 40, and each of the at least one second sub-pad 32 is connected to one of the first sub-pads 31 through a respective second via 41a.

In an example, a technical solution in which two first sub-pads 31 share one second sub-pad 32 is shown in FIG. 3. The number of the first sub-pads 31 sharing one second sub-pad 32 is not limited in the embodiments of the present application.

In the top view of the VCSEL shown in FIG. 3, only the substrate 10, the emitters 20, the first pad 30, and the second via 41a are shown. The substrate of the emitters 20 may be provided with a desired epitaxial layer based on practical design requirements, which is not limited in the present application.

Optionally, the emitter 20 includes a first distributed Bragg reflection (DBR) 21, an active layer 22, and a second DBR 23, where the first DBR 21 and the second DBR 23 have different refractive indices and are formed by periodically growing a semiconductor material with an optical thickness of an odd multiple of a quarter wavelength, and the active layer 22 is a quantum well light-emitting material.

Optionally, the VCSEL further includes an ohmic metal layer 24 on the emitter disposed between the first sub-pad 31 and the emitter 20 so that the ohmic metal layer 24 on the emitter has a good ohmic contact with a surface of the emitter 20.

Optionally, a confining oxidation layer 90 is further disposed in the first DBR 21 and configured to provide oxidation apertures, that is, to confine optical aperture for the emitter 20. A dashed line in FIG. 3 may illustrate positions of the optical apertures.

Optionally, the VCSEL further includes one negative electrode (not shown in the figure) disposed on a surface of the substrate 10 facing away from the emitters 20.

In the technical solution provided in the embodiments of the present application, one independent first sub-pad 31 is disposed on a side of each emitter 20 facing away from the substrate 10, the first sub-pad 31 is disposed on a surface of the emitter 20 and does not need to completely cover a spacing region between adjacent emitters 20, on the basis of satisfying that a minimum spacing L02 between adjacent first sub-pads 31 satisfies a preset range and ensuring that no short circuit occurs between different first sub-pads 31, in a process of forming the independent first sub-pad 31 through the photolithography and etching processes, the photoresist may be distributed in the spacing region between adjacent emitters 20 or close to the spacing region, avoiding the problem that the photoresist is easily inclined due to the too large ratio of the length to the width of the photoresist, and the emitter 20 may be disposed in the spacing region between adjacent emitters 20 or close to the spacing region, thereby reducing the minimum spacing between the emitters 20 and increasing the number and density of the emitters 20 that may be disposed on the surface of the substrate 10. The second passivation layer 41 is spaced between the second sub-pad 32 and the first sub-pad 31, the second sub-pad 32 is connected to the first sub-pad 31 through the second via 41a, the second sub-pad 32 does not need to cover the emitter 20, and on the basis of ensuring that no short circuit occurs between different second sub-pads 32, the number and position of the second sub-pads 32 may be flexibly set. In addition, the second sub-pad 32 is provided, thereby achieving the technical solution in which part or all of the first sub-pads 31 share one second sub-pad 32, thereby further achieving the technical solution in which part or all of the emitters 20 share one second sub-pad 32. In addition, the larger an area of the second sub-pad 32, the smaller the resistance of the first pad 30 so that when the first pad 30 is injected with a larger current, damage to circuit elements of the VCSEL may be avoided.

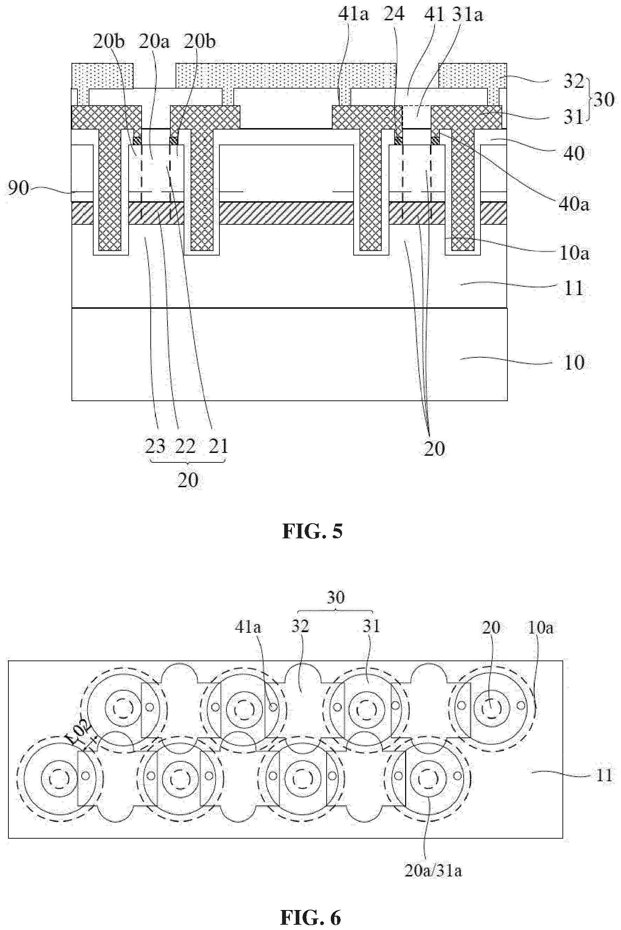

FIG. 5 is another sectional view of the VCSEL in FIG. 3 taken along the B1-B2 direction. Optionally, referring to FIG. 5, the VCSEL further includes an epitaxial layer 11 disposed between the substrate 10 and the emitters 20; and the VCSEL is provided with oxide trenches 10a arranged in an array and around the emitters 20, where a surface of the epitaxial layer 11 facing away from the substrate 10 is exposed from the oxide trenches 10a.

After the oxide trenches 10a are prepared, a film layer where the confining oxidation layer 90 is located is oxidized through an oxidation process so as to provide oxidation apertures. A surface of the epitaxial layer 11 has a better quality and a better ion doping uniformity than the substrate 10, thereby facilitating the formation of the emitters 20 with a higher yield.

Optionally, the material of the epitaxial layer 11 is the same as the material of the second DBR 23. According to the design, the epitaxial layer 11 may include the second DBR 23 and/or an ohmic metal contact layer.

FIG. 6 is another top view of a VCSEL according to an embodiment of the present application. Optionally, referring to FIG. 6, a projection of the second sub-pad 32 on the substrate 10 overlaps with a projection of a respective first sub-pad 31 on the substrate 10.

The projection of the second sub-pad 32 on the substrate 10 overlaps with the projection of the respective first sub-pad 31 on the substrate 10 so that the area of the second sub-pad 32 increases, the resistance of the first pad 30 decreases, and damage to the circuit elements of the VCSEL may be avoided when the first pad 30 is injected with a larger current.

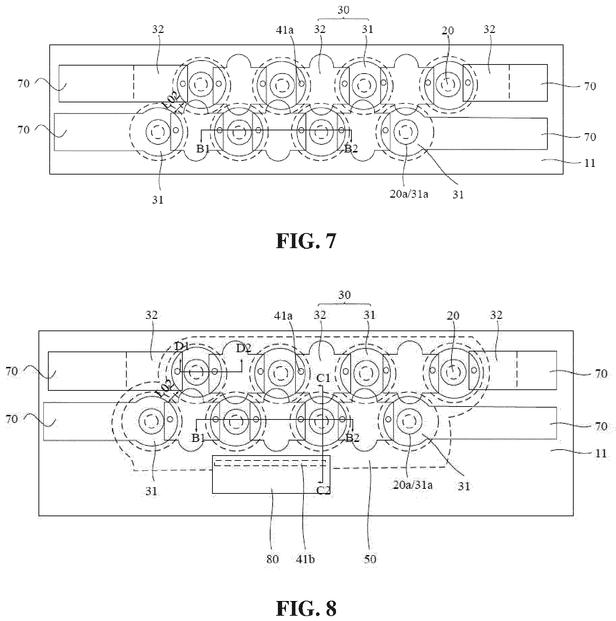

FIG. 7 is another top view of a VCSEL according to an embodiment of the present application. Optionally, referring to FIG. 7, the VCSEL further includes multiple first pad signal connecting ends 70 (that is, positive electrodes); where two second sub-pads 32 disposed at two ends of an i-th row of the emitters 20 are connected to two first pad signal connecting ends 70, respectively, where a value of i is greater than or equal to 1; and two first sub-pads 31 disposed at two ends of an (i+1)-th row of the emitters 20 are connected to two first pad signal connecting ends 70, respectively.

In an example, only two rows of the emitters are shown in FIG. 7, two second sub-pads 32 disposed at two ends of the first row of the emitters 20 are connected to two first pad signal connecting ends 70, respectively, and two first sub-pads 31 disposed at two ends of the second row of the emitters 20 are connected to two first pad signal connecting ends 70, respectively. The value of i is not further limited in the embodiments of the present application.

The second sub-pad 32 in the i-th row of the emitters 20 is connected to the first sub-pad 31 through the second via 41a, and the second sub-pad 32 transmits a first current signal of the first pad signal connecting end 70 to the emitter 20 through the first sub-pad 31. The first sub-pad 31 in the (i+1)-th row of the emitters 20 is connected to the second sub-pad 32 through the first via 41a, and the first sub-pad 31 transmits a first current signal of the first pad signal connecting end 70 to the emitter 20.

Optionally, referring to FIG. 7, the second sub-pads 32 connected to the first pad signal connecting ends 70 are disposed on a same layer and made of a same material as the first pad signal connecting ends 70; and the first sub-pads 31 connected to the first pad signal connecting ends 70 are disposed on a same layer and made of a same material as the first pad signal connecting ends 70.

The second sub-pads 32 connected to the first pad signal connecting ends 70 are disposed on a same layer and made of a same material as the first pad signal connecting ends 70 so that when the second sub-pads 32 are prepared, the first pad signal connecting ends 70 may be prepared at the same time, thereby simplifying the preparation process of the VCSEL. The interconnected first sub-pads 31 connected to the first pad signal connecting ends 70 are disposed on a same layer and made of a same material as the first pad signal connecting ends 70 so that when the first sub-pads 31 are prepared, the first pad signal connecting ends 70 may be prepared at the same time, thereby simplifying the preparation process of the VCSEL.

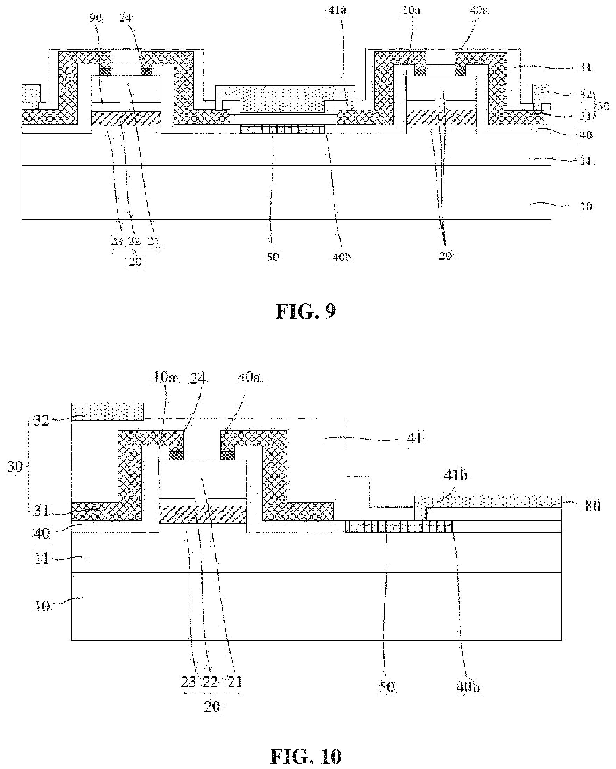

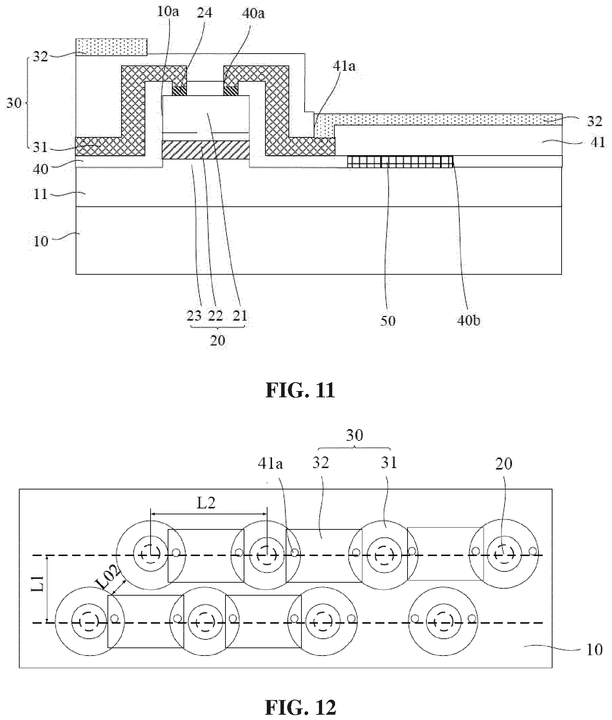

FIG. 8 is another top view of a VCSEL according to an embodiment of the present application. FIG. 9 is a sectional view of the VCSEL in FIG. 8 taken along the B1-B2 direction. FIG. 10 is a sectional view of the VCSEL in FIG. 8 taken along the C1-C2 direction. FIG. 11 is a sectional view of the VCSEL in FIG. 8 taken along the D1-D2 direction.

Optionally, referring to FIGS. 8 to 11, the VCSEL further includes an ohmic metal layer 50 on an epitaxial layer, where the ohmic metal layer 50 on the epitaxial layer is disposed on the epitaxial layer 11 and connected to the emitter 20; the first passivation layer 40 is further provided with an opening structure for the ohmic metal layer 40b; and the ohmic metal layer 50 on the epitaxial layer is disposed in the opening structure for the ohmic metal layer 40b and around the emitter 20.

Optionally, referring to FIGS. 8 to 11, the VCSEL further includes an ohmic metal layer connecting end 80 (that is, a negative electrode) insulated from the first pad 30; the second passivation layer 41 is provided with a third via 41b; and the ohmic metal layer connecting end 80 is disposed on a same layer as the second sub-pad 32 and connected to the ohmic metal layer 50 on the epitaxial layer through the third via 41b.

The ohmic metal layer connecting end 80 is configured to transmit a second current signal to the ohmic metal layer 50 on the epitaxial layer. The first pad 30 applies a first current signal to the first DBR 21. Part or all of the emitters 20 may share the first pad 30, and the second DBR 23 of each emitter 20 obtains the second current signal through the ohmic metal layer 50 on the epitaxial layer. The active layer 22 emits light under the action of a current signal, and the emitted light is reflected between the first DBR 21 and the second DBR 23 and then exits from the second DBR 21.

Optionally, based on the preceding technical solutions, referring to FIG. 5, the emitter 20 includes an emission window 20a and an edge region 20b surrounding the emission window 20a; and the first sub-pad 31 is provided with a light emission window 31a, where a projection of the light emission window 31a on the substrate 10 coincides with a projection of a respective emission window 20a on the substrate 10.

The first sub-pad 31 is provided with the light emission window 31a, and the projection of the light emission window 31a on the substrate 10 coincides with the projection of the emission window 20a on the substrate 10, thereby preventing the first sub-pad 31 from blocking the light emitted from the emission window 20a and improving the light output efficiency of the VCSEL.

Optionally, based on the preceding technical solutions, referring to FIG. 5, the projection of the second sub-pad 32 on the substrate 10 does not overlap with the projection of a respective emission window 20a on the substrate 10.

The projection of the second sub-pad 32 on the substrate 10 does not overlap with the projection of the emission window 20a on the substrate 10, thereby preventing the second sub-pad 32 from blocking the light emitted from the emission window 20a and improving the light output efficiency of the VCSEL.

Optionally, based on the preceding technical solutions, referring to FIG. 3, the first sub-pad 31 is disposed around the emitter 20 and symmetrically disposed about a center of the emitter 20.

The first sub-pad 31 is disposed around the emitter 20 and symmetrically disposed about the center of the emitter 20, thereby simplifying the layout difficulty of the first sub-pads 31.

Optionally, based on the preceding technical solutions, a sectional shape of the first sub-pad 31 in a plane where the substrate 10 is located includes any one of a circle, a regular polygon, a rectangle, or a rhombus, and the preceding shapes are centrosymmetric shapes, thereby further reducing the difficulty of manufacturing the first sub-pads 31 on the basis of simplifying the layout difficulty of the first sub-pads 31.

FIG. 12 is another top view of a VCSEL according to an embodiment of the present application. In an example, FIG. 12 shows a VCSEL improved based on the top view of the VCSEL shown in FIG. 3. In an example, based on the preceding technical solutions, referring to FIG. 12, a smallest straight-line distance L1 between centers of two emitters 20 respectively in two adjacent rows is less than a distance L2 between centers of two adjacent emitters 20 in a same row.

Based on the preceding technical solution, the smallest straight-line distance L1 between centers of two emitters 20 respectively in two adjacent rows is less than a distance L2 between centers of two adjacent emitters 20 in a same row, so that the emitters 20 may be disposed in the spacing region between adjacent emitters 20 or close to the spacing region, thereby reducing the minimum spacing between the emitters 20 and increasing the number and density of the emitters 20 that may be disposed on the surface of the substrate 10.

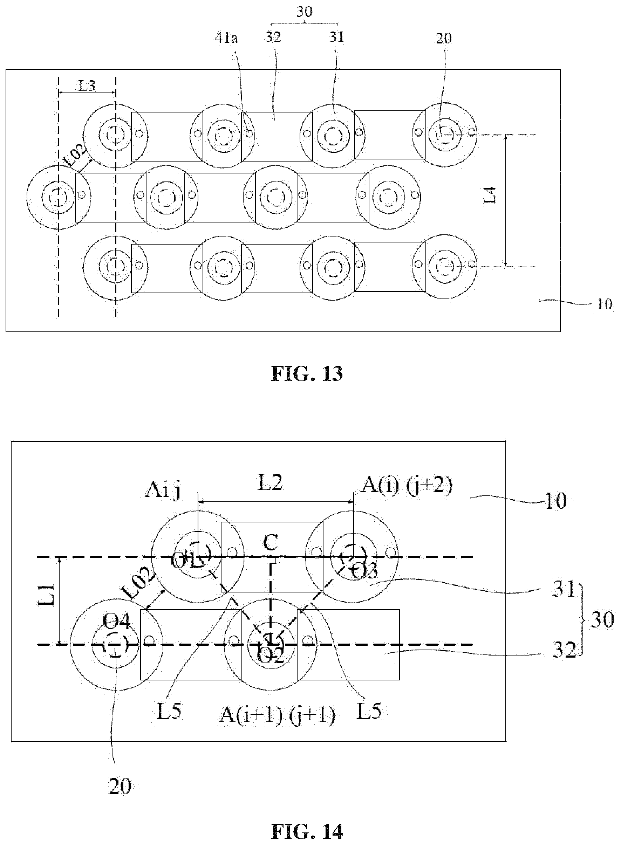

FIG. 13 is another top view of a VCSEL according to an embodiment of the present application. In an example, FIG. 13 shows a VCSEL improved based on the top view of the VCSEL shown in FIG. 3. Optionally, based on the preceding technical solutions, referring to FIG. 13, a smallest straight-line distance L3 between centers of two emitters 20 respectively in two adjacent columns is less than a distance L4 between centers of two adjacent emitters 20 in a same column.

Based on the preceding technical solution, the smallest straight-line distance L3 between centers of two emitters 20 respectively in two adjacent columns is less than a distance L4 between centers of two adjacent emitters 20 in a same column, on the basis of satisfying that the minimum spacing L02 between adjacent first sub-pads 31 satisfies the preset range and ensuring that no short circuit occurs between different first sub-pads 31, in the process of forming the independent first sub-pad 31 through the photolithography and etching processes, the photoresist may be distributed in the spacing region between adjacent emitters 20 or close to the spacing region, avoiding the problem that the photoresist is easily inclined due to the too large ratio of the length to the width of the photoresist, and the emitter 20 may be disposed in the spacing region between adjacent emitters 20 or close to the spacing region, thereby reducing the minimum spacing between the emitters 20 and increasing the number and density of the emitters 20 that may be disposed on the surface of the substrate 10.

FIG. 14 is another top view of a VCSEL according to an embodiment of the present application. In an example, FIG. 14 shows a VCSEL improved based on the top view of the VCSEL shown in FIG. 3. Optionally, based on the preceding technical solutions, referring to FIG. 14, the distance L2 between centers of two adjacent emitters in a same row is two times of the smallest straight-line distance L1 between centers of two emitters respectively in two adjacent rows, and a distance L5 from a center of an A_{(i+1) (j+1)}-th emitter 20 to a center of an Aᵢⱼ-th emitter 20 is equal to a distance L5 from the center of the A_{(i+1) (j+1)}-th emitter 20 to a center of an A_{(i) (j+2)}-th emitter 20, and where a value of i includes an integer greater than or equal to 1, and a value of j includes an integer greater than or equal to 1.

FIG. 14, in an example, shows four emitters 20 whose circle centers are O1, O2, O3, and O4, respectively. The four emitters 20 are arranged in an array of two rows and four columns. In the case where the value of i is 1 and the value of j is 2, the distance L5 from the center O2 of the A_{(i+1) (j+1)}-th emitter 20 to the center O1 of the Aᵢⱼ-th emitter 20 is equal to the distance L5 from the center O2 of the A_{(i+1) (j+1)}-th emitter 20 to the center O3 of the A_{(i) (j+2)}-th emitter 20. In addition, the smallest straight-line distance L1 between the centers of the emitters 20 in the two adjacent rows and 2 is equal to the distance L2 between the centers of the adjacent emitters 20 in the same row. A distance between O2 and C is a height line of a triangle formed by O2, O3, and O4 and is equal to the smallest straight-line distance L1 between the centers of the emitters 20 in the two adjacent rows. That is, on the basis that the product of the smallest straight-line distance L1 between the centers of the emitters 20 in the two adjacent rows and 2 is equal to the distance L2 between the centers of the adjacent emitters 20 in the same row, the center of the A(i+i) ₍ⱼ₊₁₎-th emitter 20 may be arranged on a midline perpendicular to a connecting line 01-03 connecting the centers of the A_{(i+1) (j+1)}-th emitter 20 and the A_{(i) (j+2)}-th emitter 20 that are adjacent to each other and in the same row. On the basis of satisfying that the minimum spacing L02 between adjacent first sub-pads 31 satisfies the preset range and ensuring that no short circuit occurs between different first sub-pads 31, in the process of forming the independent first sub-pad 31 through the photolithography and etching processes, the photoresist may be distributed in the spacing region between adjacent emitters 20 or close to the spacing region, avoiding the problem that the photoresist is easily inclined due to the too large ratio of the length to the width of the photoresist, thereby reducing the minimum spacing between two adjacent emitters 20 and increasing the number and density of the emitters 20 that may be disposed on the surface of the substrate 10.

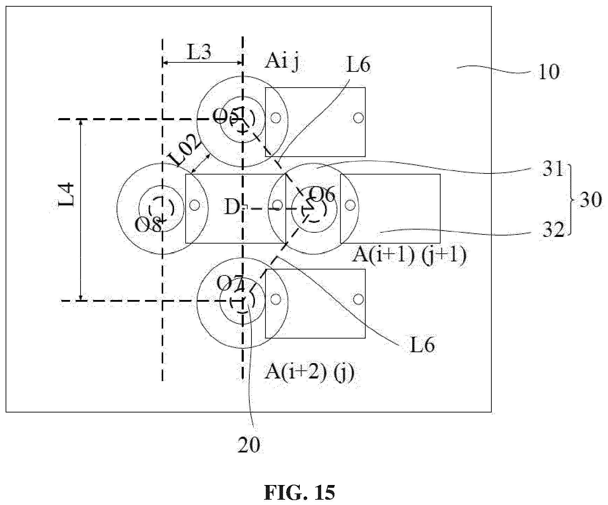

FIG. 15 is another top view of a VCSEL according to an embodiment of the present application. In an example, FIG. 15 shows a VCSEL improved based on the top view of the VCSEL shown in FIG. 3. Optionally, based on the preceding technical solutions, referring to FIG. 15, a product of the smallest straight-line distance L3 between the centers of the emitters 20 in the two adjacent columns and 2 is equal to the distance L4 between the centers of the adjacent emitters 20 in the same column, and a distance L6 from a center O6 of an A(i+i) ₍ⱼ₊₁₎-th emitter 20 to a center O5 of an Aᵢⱼ-th emitter 20 is equal to a distance L6 from the center O6 of the A(i+i) ₍ⱼ₊₁₎-th emitter 20 to a center O7 of an A_{(i+2) (j)}-th emitter 20, where a value of i includes an integer greater than or equal to 1, and a value of j includes an integer greater than or equal to 1.

FIG. 15, in an example, shows four emitters 20 whose circle centers are O5, O6, O7, and O8, respectively. The four emitters 20 are arranged in an array of three rows and three columns. The value of i is 1, the value of j is 2, and the distance L5 from the center O2 of the A_{(i+1) (j+1)}-th emitter 20 to the center O1 of the Aᵢⱼ-th emitter 20 is equal to the distance L5 from the center O2 of the A_{(i+1) (j+1)}-th emitter 20 to the center O3 of the A_{(i+2) (j)}-th emitter 20. In addition, the product of the smallest straight-line distance L3 between the centers of the emitters 20 in the two adjacent columns and 2 is equal to the distance L4 between the centers of the adjacent emitters 20 in the same column. A distance between O2 and C is a height line of a triangle formed by O2, O3, and O4 and is equal to the smallest straight-line distance L3 between the centers of the emitters 20 in the two adjacent columns. That is, on the basis that the product of the smallest straight-line distance L3 between the centers of the emitters 20 in the two adjacent columns and 2 is equal to the distance L4 between the centers of the adjacent emitters 20 in the same column. The center O6 of the A_{(i+1) (j+1)}-th emitter 20 may be arranged on a midline perpendicular to a connecting line O5-O7 connecting the centers of the Aᵢⱼ-th emitter 20 and the A_{(i+2) (j)}-th emitter 20 that are adjacent to each other and in the same column. On the basis of satisfying that the minimum spacing L02 between adjacent first sub-pads 31 satisfies the preset range and ensuring that no short circuit occurs between different first sub-pads 31, in the process of forming the independent first sub-pad 31 through the photolithography and etching processes, the photoresist may be distributed in the spacing region between adjacent emitters 20 or close to the spacing region, avoiding the problem that the photoresist is easily inclined due to the too large ratio of the length to the width of the photoresist, thereby reducing the minimum spacing between two adjacent emitters 20 and increasing the number and density of the emitters 20 that may be disposed on the surface of the substrate 10.

## Claims

1. A vertical cavity surface emitting laser (VCSEL), comprising:
a substrate;
emitters arranged in an array disposed on a surface of the substrate;
a first passivation layer, wherein the first passivation layer is disposed on a surface of the emitters arranged in the array facing away from the substrate and provided with a first via;
a second passivation layer provided with a second via; and
a first pad, wherein the first pad comprises a plurality of first sub-pads and at least one second sub-pad, a number of the plurality of first sub-pads is equal to a number of the emitters arranged in the array, each of the plurality of first sub-pads is disposed on a side of the first passivation layer facing away from the substrate and connected to a respective emitter of the emitters through the first via, the second passivation layer covers the plurality of first sub-pads and the first passivation layer, and each of the at least one second sub-pad is connected to a respective first sub-pad of the plurality of first sub-pads through the second via.

2. The VCSEL of claim 1, further comprising an epitaxial layer disposed between the substrate and the emitters arranged in the array;
wherein the VCSEL is provided with oxide trenches arranged in an array around the emitters, wherein a surface of the epitaxial layer facing away from the substrate is exposed from the oxide trenches.

3. The VCSEL of claim 1, wherein a projection of a second sub-pad of the at least one second sub-pad on the substrate overlaps with a projection of a respective first sub-pad of the plurality of first sub-pads on the substrate.

4. The VCSEL of claim 1, further comprising a plurality of first pad signal connecting ends;
wherein two second sub-pads disposed at two ends of an i-th row of the emitters are connected to two of the plurality of first pad signal connecting ends, respectively, wherein a value of i is greater than or equal to 1; and
two of the plurality of first sub-pads disposed at two ends of an (i+1)-th row of the emitters are connected to two of the plurality of first pad signal connecting ends, respectively.

5. The VCSEL of claim 4, wherein the two second sub-pads and the two of the plurality of first pad signal connecting ends, which are connected to each other, are disposed on a same layer and are made of a same material; and
the two of the plurality of first sub-pads and the two of the plurality of first pad signal connecting ends, which are connected to each other, are disposed on a same layer and are made of a same material.

6. The VCSEL of claim 1, further comprising an ohmic metal layer on an epitaxial layer, wherein the ohmic metal layer on the epitaxial layer is connected to a respective emitter of the emitters;
the first passivation layer is further provided with an opening structure for the ohmic metal layer; and
the ohmic metal layer on the epitaxial layer is disposed in the opening structure for the ohmic metal layer and around the respective emitter.

7. The VCSEL of claim 6, further comprising an ohmic metal layer connecting end insulated from the first pad;
wherein the second passivation layer is provided with a third via; and
the ohmic metal layer connecting end is disposed on a same layer as the at least one second sub-pad and connected to the ohmic metal layer on the epitaxial layer through the third via.

8. The VCSEL of claim 1, wherein each of the emitters comprises an emission window and an edge region surrounding the emission window; and
each of the plurality of first sub-pads is provided with a light emission window, wherein a projection of the light emission window on the substrate coincides with a projection of a respective emission window on the substrate.

9. The VCSEL of claim 8, wherein a projection of a second sub-pad of the at least one second sub-pad on the substrate does not overlap with a projection of a respective emission window on the substrate.

10. The VCSEL of claim 8, wherein a first sub-pad of the plurality of first sub-pads is disposed around a respective emitter of the emitters and symmetrically disposed about a center of the respective emitter.

11. The VCSEL of claim 10, wherein a sectional shape of the first sub-pad in a plane where the substrate is located comprises one of a circle, a regular polygon, a rectangle, or a rhombus.

12. The VCSEL of any one of claims 1 to 11, wherein a smallest straight-line distance between centers of two emitters respectively in two adjacent rows is less than a distance between centers of two adjacent emitters in a same row.

13. The VCSEL of any one of claims 1 to 11, wherein a smallest straight-line distance between centers of two emitters respectively in two adjacent columns is less than a distance between centers of two adjacent emitters in a same column.

14. The VCSEL of claim 12, wherein the distance between centers of two adjacent emitters in a same row is two times of the smallest straight-line distance between centers of two emitters respectively in two adjacent rows, and a distance from a center of an A_{(i+1) (j+1)}-th emitter to a center of an Aᵢⱼ-th emitter is equal to a distance from the center of the A_{(i+1) (j+1)}-th emitter to a center of an A_{(i) (j+2)}-th emitter, and wherein a value of i comprises an integer greater than or equal to 1, and a value of j comprises an integer greater than or equal to 1.

15. The VCSEL of claim 13, wherein the distance between centers of two adjacent emitters in a same column is two times of the smallest straight-line distance between centers of two emitters respectively in two adjacent columns, and a distance from a center of an A_{(i+1) (j+1)}-th emitter to a center of an Aᵢⱼ-th emitter is equal to a distance from the center of the A_{(i+1) (j+1)}-th emitter to a center of an A_{(i+2) (j)}-th emitter, wherein a value of i comprises an integer greater than or equal to 1, and a value of j comprises an integer greater than or equal to 1.
